# EUROPEAN PATENT APPLICATION

(11) **EP 1 380 670 A1**
(43) Date of publication of application: **14.01.2004**
(21) Application number: 02710302.7
(22) Date of filing: 16.01.2002
(51) Int. Cl.: C23C 14/34, C23C 14/08, G11B 7/24, G11B 7/26

(54) **ZNS-SIO2 SPUTTERING TARGET AND OPTICAL RECORDING MEDIUM HAVING ZNS-SIO2 PROTECTIVE FILM FOR PHASE CHANGE TYPE OPTICAL DISK FORMED BY USING SAID TARGET**

(30) Priority: 13.04.2001 JP 2001115658
(71) Applicant: Nikko Materials Company, Limited, Tokyo 105-8407 (JP)
(72) Inventor: YAHAGI, Masataka, Isohara Fact. Nikko Mat. Co. Ltd, Kitaibaraki-shi, Ibaraki 319-1535 (JP); TAKAMI, Hideo, Isohara Fact. Nikko Mat. Co. Ltd., Kitaibaraki-shi, Ibaraki 319-1535 (JP)
(74) Representative: Meddle, Alan Leonard
(86) International application number: PCT/JP2002/000239
(87) International publication number: WO 2002/083973

(57) **Abstract**

The present invention is a ZnS-SiO₂ sputtering target characterized in containing, as an additive, 0.001 to 5wt% of Na, K or one or more types selected from the oxides thereof. By enabling the stable manufacture of a target at low cost and in which the SiO₂ crystal grain is minute and of a high density of 95% or more, obtained is a sputtering target for forming an optical disc protective film capable of further improving the evenness of deposition and increasing the productivity rate, and an optical recording medium having formed thereon a ZnS-SiO₂ phase change optical disc protective film upon employing the ZnS-SiO₂ sputtering target. a

## Description

### Technical Field

The present invention relates particularly to a ZnS-SiO₂ sputtering target effective in forming a ZnS-SiO₂ phase change optical disc protective film capable of reducing particles (raising dust) and nodules generated at the time of sputtering upon forming a film with sputtering, and improving the productivity of high-density products without much variation in the quality, as well as to an optical recording medium having formed thereon the ZnS-SiO₂ phase change optical disc protective film using such target.

### Background Art

In recent years, high-density rewritable optical disc technology capable of reading/writing without requiring a magnetic head has been developed, and is rapidly attracting attention. This optical disc can be classified into the three categories of read-only, write-once and rewritable. Particularly, the phase change method employed in the rewritable type discs is attracting attention. The fundamental principle of the reading/writing employing this phase change optical disc is briefly described below.

This phase change optical disc performs the reading/writing of information by heating and increasing the temperature of a recording thin film on a substrate by irradiating a laser beam thereto, and generating a crystallographic phase change (amorphous crystal) in the structure of such recording thin film. More specifically, the reproduction (reading) of information is conducted by detecting the change in the reflectivity caused by the change in the optical constant of the phase.

The aforementioned phase change is performed with the irradiation of a laser beam narrowed down to a diameter of approximately 1 to several im. Here, for example, when a 1im laser beam passes through at a linear velocity of 10m/s, light is irradiated to a certain point on the optical disc for 100ns, and it is necessary to perform the aforementioned phase change and detect the reflectivity within such time frame.

Moreover, in order to realize the foregoing crystallographic phase change; that is, the phase change of the amorphous and crystal, not only will the phase change recording layer be subject to fusion and quenching more than once, the peripheral dielectric protective layer and aluminum alloy will also be repeatedly subject thereto.

In light of the above, a phase change optical disc has a four-layer structure wherein, for instance, both sides of a Ge-Sb-Te recording thin film layer are sandwiched with a ZnS • SiO₂ high-melting point dielectric, and an aluminum alloy reflective layer is additionally provided thereto.

Among the above, in addition to being demanded of an optical function capable of increasing the absorption of the amorphous portion and crystal portion and which has a large reflectivity difference, the reflective layer and protective layer are also demanded of a function for preventing the deformation caused by heat of the recording thin film as well as a function for controlling the thermal conditions upon recording (o.f. *"Kogaku"* magazine, volume 26, no. 1, pages 9 to 15).

As described above, the protective layer of a high-melting point dielectric must be durable against repeated thermal stress caused by the heating and cooling, must not allow such thermal effect to influence the reflective film or other areas, and it is also required to be thin, of low reflectivity, and possess strength to prevent deterioration. From this perspective, the dielectric protective layer plays an important role.

The dielectric protective layer described above is usually formed with the sputtering method. This sputtering method makes a positive electrode substrates and a negative electrode target face each other, and generates an electric field by applying a high voltage between the substrates thereof and the targets under an inert gas atmosphere. The sputtering method employs a fundamental principle where plasma is formed pursuant to the collision of electrons, which are ionized at such time, and the inert gas, the positive ion in this plasma extrudes the target structured atoms by colliding with the target (negative electrode) surface, and the extruded atoms adhere to the opposing substrate surface.

Conventionally, since the aforementioned protective layer is demanded of permeability, heat resistance, and so on in a visible optical band,sputtering is conducted with a ceramic target such as ZnS-SiO₂ in order to form a thin film of approximately 500 to 2000Å.

These materials are deposited with a high-frequency sputtering (RF) device, a magnetron-sputtering device, or with a DC (direct current) sputtering device upon conducting special processing to the target material.

The sputtering face of the target can be made even and smooth by miniaturizing and highly densifying the crystal grain of the ZnS-SiO₂ target, whereby yielding a characteristic of reducing particles and nodules as well as prolonging the target life. It is well known that the productivity of optical discs can be improved as a result thereof.

Nevertheless, with respect to the SiO₂ used in a conventional ZnS-SiO₂ target, employed were those having a high purity of 4N or more and having an average grain diameter of 0.1 to 20 *µ*m, and are ordinarily manufactured by being sintered between 800 and 1200ºC. With this temperature range, however, the SiO₂ itself will not deform or react with ZnS.

Thus, a ZnS-SiO₂ target manufactured as above easily creates a space between the ZnS and SiO₂, which becomes more noticeable when the SiO₂ is miniaturized, and, since the sintering of the ZnS is also prevented thereby, there is a problem in that the target density will deteriorate.

Therefore, conventionally, it was necessary to make the manufacturing conditions for hot pressing or the like as high temperature and high pressure as possible in order to realize high densification. Nonetheless, for example, when manufacturing with hot pressing, more time is required for a single process pursuant to the increase in temperature, and the graphite mold retains its strength pursuant to the increase in pressure. It is thereby necessary to make the peripheral radial thickness thicker, and to reduce the load area portion. As a result, there is a problem in that the productivity per hot pressing batch will decrease significantly.

Contrarily, although the hot pressing device may be enlarged in order to enlarge the graphite mold itself, this will lead to increased costs for such hot pressing device and graphite mold.

Due to the foregoing reasons, it was not conventionally possible to obtain a sputtering target for a ZnS-SiO₂ phase change optical disc protective film at a low cost.

Accordingly, in general, there was no choice but to use a low-density target. As a result, upon forming the film with sputtering, particles (raising dust) and nodules would arise during such sputtering, and there is a problem in that the stability and quality of the deposition will decrease, thereby leading to the deterioration of productivity.

### Disclosure of the Invention

An object of the present invention is to enable the stable manufacture of a target at low cost and in which the SiO₂ crystal grain is fine and of a high density of 90% or more, and to thereby obtain a sputtering target for forming an optical disc protective film capable of further improving the stability of deposition and increasing the productivity rate, and an optical recording medium having formed thereon a ZnS-SiO₂ phase change optical disc protective film upon employing the ZnS-SiO₂ sputtering target.

In order to achieve the foregoing object, as a result of intense study, the present inventors discovered that by adding an additive to the ZnS-SiO₂, space between the ZnS can be reduced, high densification can be easily realized even with fine the SiO₂, generation of particles (raising dust) and nodules arising at the time of sputtering can be reduced without detriment to the characteristics as a protective film, and uniformity of the film thickness can also be improved.

Based on the foregoing discovery, the present invention provides:
1. A ZnS-SiO₂ sputtering target characterized in containing, as an additive, 0.001 to 5wt% of Na, K or one or more types selected from the oxides thereof;
2. A ZnS-SiO₂ sputtering target characterized in containing, as an additive, 0.001 to 5wt% of alkali earth metal or one or more types selected from the oxides thereof;
3. A ZnS-SiO₂ sputtering target according to paragraph 2 above, characterized in containing, as an additive, alkali metal or one or more types selected from the oxides thereof in a total amount of 0.001 to 5wt% together with alkali earth metal or the oxides thereof;
4. A ZnS-SiO₂ sputtering target according to each of paragraphs 1 to 3 above, characterized in containing, as an additive, 0.001 to 5wt% of boron, aluminum, phosphorus, arsenic or one or more types selected from the oxides thereof;
5. A ZnS-SiO₂ sputtering target according to each of paragraphs 1 to 4, characterized in having a relative density of 95% or more;
6. A ZnS-SiO₂ sputtering target according to each of paragraphs 1 to 5, characterized in that the average grain diameter of the SiO₂ crystal grain is 0.1 to 30 *µ*m; and
7. An optical recording medium having formed thereon a ZnS-SiO₂ phase change optical disc protective film upon employing the ZnS-SiO₂ sputtering target according to each of claims 1 to 6.

### Brief Description of the Drawings

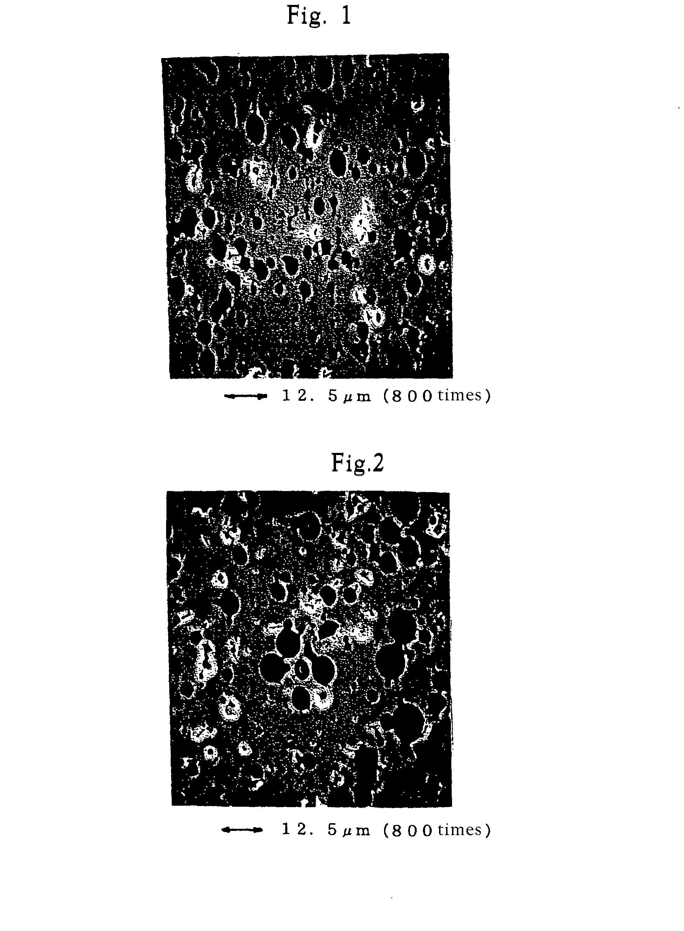

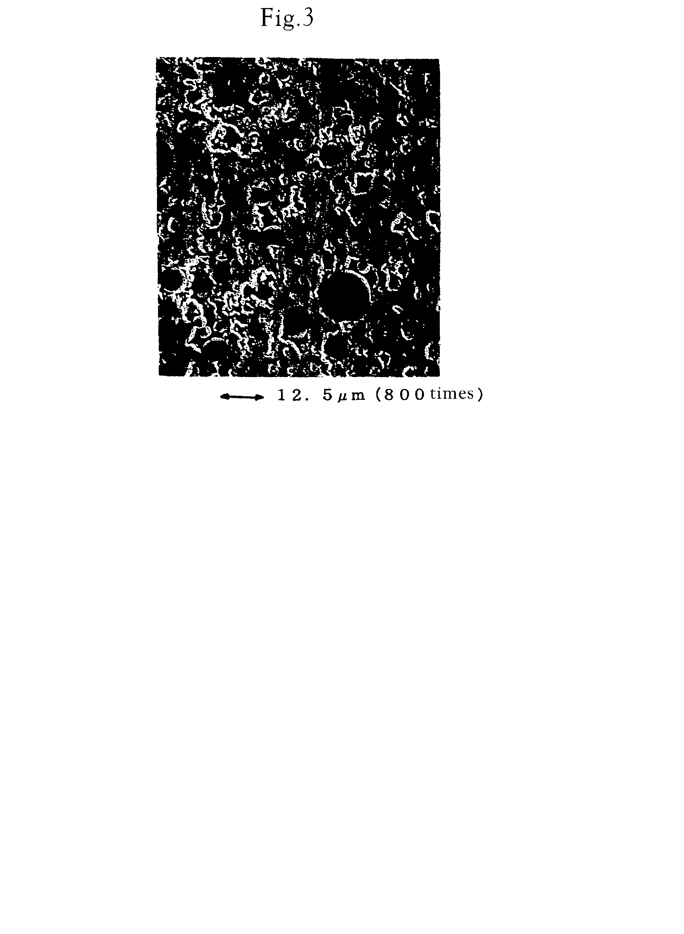

Fig. 1 is a microphotograph of the target surface obtained pursuant to Example 1; Fig. 2 is a microphotograph of the target surface obtained pursuant to Example 4; and Fig. 3 is a microphotograph of the target surface obtained in Comparative Example 1.

### Best Mode for Carrying Out the Invention

The ZnS-SiO₂ sputtering target of the present invention contains, as an additive, 0.001 to 5wt% of Na, K or one or more types selected from the oxides thereof, or 0.001 to 5wt% of alkali earth metal or one or more types selected from the oxides thereof. A high-density ZnS-SiO₂ sputtering target can be obtained by adding thereto Na, K or the oxides thereof. Further, a ZnS-SiO₂ sputtering target having higher density and high corrosion resistance can be obtained by adding thereto alkali earth metal or the oxides thereof.

Moreover, 0.001 to 5wt% of alkali metal or one or more types selected from the oxides thereof may be additionally added to the aforementioned ZnS-SiO₂ sputtering target containing 0.001 to 5wt% of alkali earth metal or one or more types selected from the oxides thereof. Alkali metal includes Li, Na, K, Rb, Cs and Fr; and alkali earth metal includes Be, Mg, Ca, Sr, Ba and Ra.

In addition, 0.001 to 5wt% of boron, aluminum, phosphorus, arsenic or the oxides thereof may also be contained in the above. Upon adding the foregoing materials, it is particularly preferable that the amount of such materials is not greater than double the amount of the additive selected from Na, K or alkali earth metal or the oxides thereof.

Since the additive will be ineffective if the additive amount of the additive or the like selected from the aforementioned Na, K or alkali earth metal or the oxides thereof is less than 0.001wt%, and the film characteristics will change largely or the corrosion resistance will deteriorate, which is not preferable, if the additive amount exceeds 5wt%, the total amount has been set between 0.001 and 5wt%.

The addition of boron, aluminum, phosphorus, arsenic or the oxides thereof will further improve the corrosion resistance. Since the additive will be ineffective if less then 0.001wt% and the film characteristics will change largely or the corrosion resistance will deteriorate, which is not preferable, if the additive amount exceeds 10wt%, the total amount has been set between 0.001 and 10wt%. The foregoing additive and additive amount may be suitable selected and adjusted in accordance with the demanded characteristics of the sputtering target for forming the ZnS-SiO₂ phase change optical disc protective film.

The target is manufactured by evenly dispersing and mixing the foregoing additive elements in the ZnS powder and SiO₂ powder, and molding this with hot pressing or the like. Preferably, after mixing and heating the aforementioned additive elements or the salt thereof and SiO₂ powder, the remaining ZnS powder is mixed thereto and molded with hot pressing.

Obtained thereby is a sputtering target for forming the ZnS-SiO₂ phase change optical disc protective film with not much space between the ZnS and SiO₂, and which has a relative density of 95% or more.

Moreover, by merely adding the foregoing materials, the ZnS-SiO₂ target crystal grain can be miniaturized and highly densified, and, therefore, yielded is a significant effect where the sputtering face of the target can be made even and smooth, particles and nodules at the time of sputtering can be reduced, and the target life can be prolonged. As a result, the productivity of the optical recording medium having formed thereon a ZnS-SiO₂ phase change optical disc protective film will increase, and a material superior in quality can be obtained thereby.

It is also possible to further improve the aforementioned characteristics by making the average grain diameter of the SiO₂ crystal grain 0.1 to 30 *µ*m.

### Examples and Comparative Examples

The present invention is now described with reference to the Examples and Comparative Examples. These Examples are merely illustrative, and the present invention shall in no way be limited thereby. In other words, the present invention shall only be limited by the scope of claim for a patent, and shall include the various modifications other than the Examples of this invention.

### (Example 1)

SiO₂ powder having a purity of 99.99% or higher was mixed with ZnS at a ratio of 20mol%, and 0.1wt% of Na₂O was further added and mixed thereto.

This mixed powder was filled in a graphite die, and hot pressed under the conditions of an Ar atmosphere, a pressure of 150kg/cm², and a temperature of 1000ºC. The target obtained thereby had a relative density of 99%. The miorophotograph of the surface of this target is shown in Fig. 1.

The black spherical shapes in Fig. 1 represent the SiO₂, and the average grain diameter of the SiO₂ crystal grain was 10ìm or less, and space between the surfaces of ZnS and SiO₂ could hardly be acknowledged. As a result, obtained was a high-density sputtering target for forming a ZnS-SiO₂ phase change optical disc protective film.

### (Example 2)

SiO₂ powder having a purity of 99.99% or higher was mixed with ZnS at a ratio of 20mol%, and 0.1wt% of Na₂O and 0.01wt% of MgO were further added and mixed thereto.

This mixed powder was filled in a graphite die as with Example 1, and hot pressed under the conditions of an Ar atmosphere, a pressure of 150kg/cm², and a temperature of 1000°C. The target obtained thereby had a relative density of 97%.

Similar to Example 1, the average grain diameter of the SiO₂ crystal grain was 10im or less, and space between the surfaces of ZnS and SiO₂ could hardly be acknowledged. As a result, obtained was a high-density sputtering target suitable for forming a ZnS-SiO₂ phase change optical diso protective film.

### (Example 3)

SiO₂ powder having a purity of 99.99% or higher was mixed with ZnS at a ratio of 20mol%, and 1.0wt% of Na₂O and 0.3wt% of Al₂O were further added and mixed thereto.

This mixed powder was filled in a graphite die as with Example 1, and hot pressed under the conditions of an Ar atmosphere, a pressure of 150kg/cm², and a temperature of 1000ºC. The target obtained thereby had a relative density of 97%.

Similar to Example 1, the average grain diameter of the SiO₂ crystal grain was 10 *µ*m or less, and space between the surfaces of ZnS and SiO₂ could hardly be acknowledged. As a result, obtained was a high-density sputtering target suitable for forming a ZnS-SiO₂ phase change optical diso protective film.

### (Example 4)

SiO₂ powder having a purity of 99.99% or higher was evenly mixed with ZnS at a ratio of 20mol%, and 0.1wt% of Na₂O, 0.01wt% of CaO and 0.1wt% of Al₂O₃ were further added and mixed thereto.

This mixed powder was filled in a graphite die, and hot pressed under the conditions of an Ar atmosphere, a pressure of 150kg/cm², and a temperature of 1000ºC. The target obtained thereby had a relative density of 97%. As a result, obtained was a high-density sputtering target for forming a ZnS-SiO₂ phase change optical disc protective film. The SEM photograph thereof is shown in Fig. 2.

The black spherical shapes in Fig. 1 represent the SiO₂, and the average grain diameter of the SiO₂ crystal grain was 10 *µ*m or less, and space between the surfaces of ZnS and SiO₂ could hardly be acknowledged.

### (Example 5)

SiO₂ powder having a purity of 99.99% or higher was mixed with ZnS at a ratio of 20mol%, and 1.0wt% of Na₂O, 0.5wt% of BaO and 0.1wt% of P₂O₅ were further added and mixed thereto.

This mixed powder was filled in a graphite die as with Example 1, and hot pressed under the conditions of an Ar atmosphere, a pressure of 150kg/cm², and a temperature of 1000ºC. The target obtained thereby had a relative density of 97%.

Similar to Example 1, the average grain diameter of the SiO₂ crystal grain was 10 *µ*m or less, and space between the surfaces of ZnS and SiO₂ could hardly be acknowledged. As a result, obtained was a high-density sputtering target suitable for forming a ZnS-SiO₂ phase change optical disc protective film.

### (Example 6)

SiO₂ powder having a purity of 99.99% or higher was mixed with ZnS at a ratio of 20mol%, and 0.1wt% of K₂O was further added and mixed thereto.

This mixed powder was filled in a graphite die as with Example 1, and hot pressed under the conditions of an Ar atmosphere, a pressure of 150kg/cm², and a temperature of 1000°C. The target obtained thereby had a relative density of 99%, and particularly showed significant improvement in density.

Similar to Example 1, the average grain diameter of the SiO₂ crystal grain was 10 *µ*m or less, and space between the surfaces of ZnS and SiO₂ could hardly be acknowledged. As a result, obtained was a high-density sputtering target suitable for forming a ZnS-SiO₂ phase change optical disc protective film.

### (Example 7)

SiO₂ powder having a purity of 99.99% or higher was mixed with ZnS at a ratio of 20mol%, and 0.1wt% of K₂O and 0.1wt% of Al₂O₃ were further added and mixed thereto.

This mixed powder was filled in a graphite die as with Example 1, and hot pressed under the conditions of an Ar atmosphere, a pressure of 150kg/cm², and a temperature of 1000ºC. The target obtained thereby had a relative density of 97%.

Similar to Example 1, the average grain diameter of the SiO₂ crystal grain was 10 *µ*m or less, and space between the surfaces of ZnS and SiO₂ could hardly be acknowledged. As a result, obtained was a high-density sputtering target suitable for forming a ZnS-SiO₂ phase change optical disc protective film.

### (Example 8)

SiO₂ powder having a purity of 99.99% or higher was mixed with ZnS at a ratio of 20mol%, and 2.0wt% of K₂O, 0.1wt% of MgO and 0.1wt% of Al were further added and mixed thereto.

This mixed powder was filled in a graphite die as with Example 1, and hot pressed under the conditions of an Ar atmosphere, a pressure of 150kg/cm², and a temperature of 1000°C. The target obtained thereby had a relative density of 97%.

Similar to Example 1, the average grain diameter of the SiO₂ crystal grain was 10 *µ*m or less, and space between the surfaces of ZnS and SiO₂ could hardly be acknowledged. As a result, obtained was a high-density sputtering target suitable for forming a ZnS-SiO₂ phase change optical disc protective film.

### (Example 9)

SiO₂ powder having a purity of 99.99% or higher was mixed with ZnS at a ratio of 20mol%, and 0.2wt% of MgO and 0.1wt% of CaO were further added and mixed thereto.

This mixed powder was filled in a graphite die as with Example 1, and hot pressed under the conditions of an Ar atmosphere, a pressure of 150kg/cm², and a temperature of 1000°C. The target obtained thereby had a relative density of 98%.

Similar to Example 1, the average grain diameter of the SiO₂ crystal grain was 10 *µ*m or less, and space between the surfaces of ZnS and SiO₂ could hardly be acknowledged. As a result, obtained was a high-density sputtering target suitable for forming a ZnS-SiO₂ phase change optical disc protective film.

### (Example 10)

SiO₂ powder having a purity of 99.99% or higher was mixed with ZnS at a ratio of 20mol%, and 0.5wt% of CaO and 0.1wt% of Al₂O₃ were further added and mixed thereto.

This mixed powder was filled in a graphite die as with Example 1, and hot pressed under the conditions of an Ar atmosphere, a pressure of 150kg/cm², and a temperature of 1000ºC. The target obtained thereby had a relative density of 97%.

Similar to Example 1, the average grain diameter of the SiO₂ crystal grain was 10 *µ*m or less, and space between the surfaces of ZnS and SiO₂ could hardly be acknowledged. As a result, obtained was a high-density sputtering target suitable for forming a ZnS-SiO₂ phase change optical disc protective film.

### (Example 11)

SiO₂ powder having a purity of 99.99% or higher was mixed with ZnS at a ratio of 20mol%, and 0.1wt% of Li₂O, 0.1wt% of B₂O₃ and 0.01wt% of As were further added and mixed thereto.

This mixed powder was filled in a graphite die as with Example 1, and hot pressed under the conditions of an Ar atmosphere, a pressure of 150kg/cm², and a temperature of 1000ºC. The target obtained thereby had a relative density of 98%.

Similar to Example 1, the average grain diameter of the SiO₂ crystal grain was 10 *µ*m or less, and space between the surfaces of ZnS and SiO₂ could hardly be acknowledged. As a result, obtained was a high-density sputtering target suitable for forming a ZnS-SiO₂ phase change optical disc protective film.

Moreover, similar results were obtained for additions of components not described in the foregoing Examples. The present specification exemplified the 11 representative Examples above.

### (Comparative Example 1)

SiO₂ powder having a purity of 99.99% or higher was evenly mixed with ZnS at a ratio of 20mol%.

This mixed powder was filled in a graphite die, and hot pressed under the conditions of an Ar atmosphere, a pressure of 150kg/cm², and a temperature of 1000°C. The target obtained thereby had a relative density of 94%. As a result, obtained was a sputtering target for forming a ZnS-SiO₂ phase change optical disc protective film inferior to the density yielded in the Examples of the present invention.

The microphotograph of the surface of this target is shown in Fig. 3. Similar to the above, the black spherical shapes in Fig. 3 represent the SiO₂, and the average grain diameter thereof was 10 *µ*m to 20 *µ*m, and many spaces between the surfaces of ZnS and SiO₂ could be acknowledged.

### (Comparative Example 2)

SiO₂ powder having a purity of 99.99% or higher was evenly mixed with ZnS at a ratio of 20mol%, and 0.5wt% of Al₂O₃ was further added and mixed thereto.

This mixed powder was filled in a graphite die, and hot pressed under the conditions of an Ar atmosphere, a pressure of 150kg/cm², and a temperature of 1000ºC. The target obtained thereby had a relative density of 91%. As a result, obtained was a sputtering target for forming a ZnS-SiO₂ phase change optical disc protective film inferior to the density yielded in the Examples of the present invention. Further, the average grain diameter thereof was 10 *µ*m to 20 *µ*m, and many spaces between the surfaces of ZnS and SiO₂ could be acknowledged.

### Effects of the Invention

By adding the additives of the present invention, space between the ZnS can be reduced, and high densification can be easily realized even upon miniaturizing the SiO₂. Thus, a superior effect is yielded of being able to obtain a sputtering target for forming an optical disc protective film capable of suppressing the generation of particles (raising dust) and nodules arising at the time of sputtering without detriment to the characteristics as a protective film, improving the stability of deposition and increasing the productivity rate, and an optical recording medium having formed thereon a ZnS-SiO₂ phase change optical disc protective film upon employing the ZnS-SiO₂ sputtering target.

## Claims

1. A ZnS-SiO₂ sputtering target **characterized in** containing, as an additive, 0.001 to 5wt% of Na, K or one or more types selected from the oxides thereof.

2. A ZnS-SiO₂ sputtering target **characterized in** containing, as an additive, 0.001 to 5wt% of alkali earth metal or one or more types selected from the oxides thereof.

3. A ZnS-SiO₂ sputtering target according to claim 2, **characterized in** containing, as an additive, alkali metal or one or more types selected from the oxides thereof in a total amount of 0.001 to 5wt% together with alkali earth metal or the oxides thereof.

4. A ZnS-SiO₂ sputtering target according to each of claims 1 to 3, **characterized in** containing, as an additive, 0.001 to 5wt% of boron, aluminum, phosphorus, arsenic or one or more types selected from the oxides thereof.

5. A ZnS-SiO₂ sputtering target according to each of claims 1 to 4, **characterized in** having a relative density of 95% or more.

6. A ZnS-SiO₂ sputtering target according to each of claims 1 to 5, **characterized in that** the average grain diameter of the SiO₂ crystal grain is 0.1 to 30 *µ*m.

7. An optical recording medium having formed thereon a ZnS-SiO₂ phase change optical disc protective film upon employing the ZnS-SiO₂ sputtering target according to each of claims 1 to 6.
